# EUROPEAN PATENT SPECIFICATION

(11) **EP 1 521 121 B1**
(45) Date of publication and mention of the grant of the patent: **03.07.2013**
(21) Application number: 04256106.8
(22) Date of filing: 01.10.2004
(51) Int. Cl.: G03F 7/20

(54) **Cooling technique**
Kühltechnik
Technique de refroidissement

(30) Priority: 02.10.2003 JP 2003344012
(43) Date of publication of application: 06.04.2005
(73) Proprietor: CANON KABUSHIKI KAISHA, Tokyo (JP)
(72) Inventor: Emoto, Keiji,, Tokyo (JP)
(74) Representative: TBK

(56) References cited:
- US-A- 5 413 167
- PATENT ABSTRACTS OF JAPAN vol. 2003, no. 12, 5 December 2003 (2003-12-05) -& JP 2004 159493 A (NIKON CORP), 3 June 2004 (2004-06-03)
- PATENT ABSTRACTS OF JAPAN vol. 1995, no. 11, 26 December 1995 (1995-12-26) -& JP 07 226371 A (DAINIPPON SCREEN MFG CO LTD), 22 August 1995 (1995-08-22)
- PATENT ABSTRACTS OF JAPAN vol. 013, no. 326 (C-620), 24 July 1989 (1989-07-24) & JP 01 104349 A (NIPPON TELEGR & TELEPH CORP <NTT>), 21 April 1989 (1989-04-21)

## Description

### FIELD OF THE INVENTION AND RELATED ART

This invention relates to a cooling technique suitably usable to an exposure apparatus for manufacture of devices such as semiconductor devices having a fine pattern, or to precision measuring devices, for example.

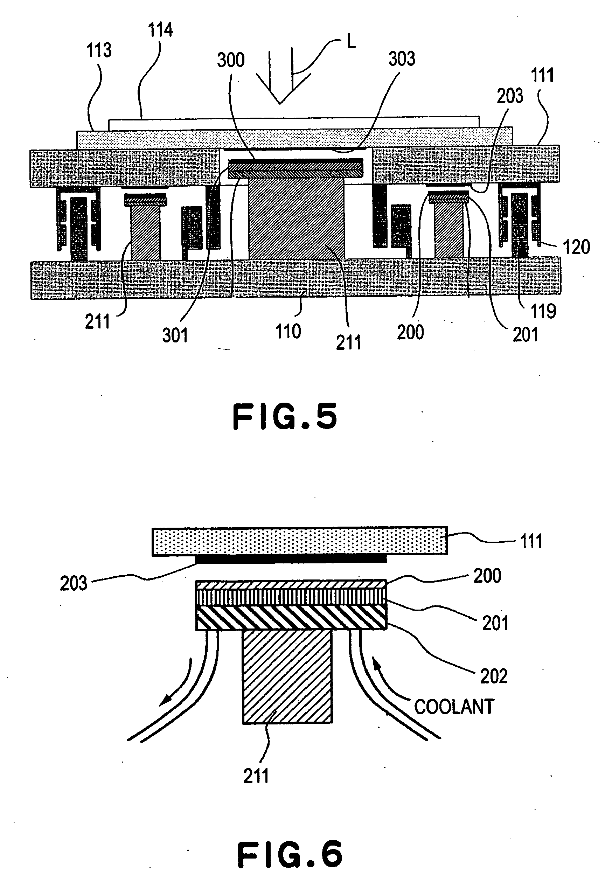

Referring to Figures 5 and 6, a structure of a positing device such as disclosed in Japanese Laid-Open Patent Application, Publication No. 2003-58258 will be explained. Figure 5 illustrates a positioning device disposed in a vacuum ambience, for performing high-precision positioning, as well as a cooling mechanism therefor. Figure 6 shows details of the cooling mechanism.

In Figure 5, a substrate 114such as a semiconductor wafer is placed on a chuck 113 which is supported by a top plate 111. The top plate 111 is floated by non-contact self-weight compensating mechanism (not shown) whose spring characteristic can be almost disregarded. Also, the top plate 111 is positioned without contact, by means of a linear motor (119, 120). With this arrangement, approximately complete vibration insulation is achieved, and high precision positioning is enabled.

On the other hand, since the substrate 114, the chuck 113 and the top plate 111 are completely floated in vacuum, there is no escape for exposure heat L flowing into the substrate 114 or for heat generated in the chuck 113. Thus, use of a cooling mechanism is inevitable. To this end, and in order to cool the chuck 113 and the top plate 111 while keeping the advantages of vibration insulation and of the non-contact supporting drive, radiation plates 300 and 200 being temperature controlled to about 0 to 10 °C are disposed opposed to the respective subjects of cooling (i.e., a heat dissipating plate 303 intimately contacted to the chuck 113, and a heat dissipating plate 203 intimately contacted the top plate 111). This enables cooling of the chuck 113 and top plate 111 without contact thereto. The radiation plates 200 are controlled at a low temperature by means of Peltier device 201 as shown in Figure 6, and also the radiation plate 300 is controlled similarly at a low temperature by means of a Peltier device 301. The back faces of the Peltier devices 201 and 301 are cooled by a coolant of a temperature of about 23 °C which is the same temperature of the positioning device structure 110 and 211.

With the cooling based on radiation, if the temperature difference between the subject of cooling and the radiation plate is not large, a desired cooling rate is not obtainable. Therefore, usually, a temperature difference of about 10 to 20 °C should be set. Thus, if the cooling subject is 23 °C, the radiation plate has to be made 10 °C or less. Furthermore, while the foregoing example uses Peltier devices, in some cases it is difficult to use such Peltier device. For example, if an electric current is applied to the Peltier device to actuate the same, a magnetic field change attributable to a change in electric current inside the device may occur. Therefore, if it is incorporated into an EB (electron beam) exposure apparatus, the exposure precision may be adversely affected thereby. In such case, Peltier devices can not be used.

The temperature of the radiation plate may be directly controlled by use of a coolant of 10 °C or less. However, since in that case the temperature of piping structure extending from the coolant temperature adjusting device up to the radiation plate is also lowered, and thus the temperature of the structure of the positioning device as a whole changes. This causes thermal deformation and degradation of the positioning precision.

It is therefore desirable to develop cooling means by which, except Peltier device, a radiation plate can be controlled at a low temperature without adversely affecting the positioning precision.

Document US 5 413 167 A discloses a wafer cooling device which includes a wafer chuck; a heat exchanger having an internal structure for circulation of cooling water therethrough; and a flexible heat pipe for providing heat communication between the wafer chuck and the heat exchanger.

Document JP 07 226371 A discloses a substrate cooling device. An operating fluid-containing chamber which is formed on a substrate mounting plate is charged with operating fluid which is evaporated at a prescribed temperature. A lower wick and an upper wick which both induce a capillary phenomenon are provided on the ceiling of the operating fluid-containing chamber extending from the operating fluid. When a substrate W is placed on the substrate mounting plate, the operating fluid coming up to the upper wick is evaporated to absorb a latent heat for cooling down the substrate mounting plate. In result, the substrate W is cooled down. The vapor of operating fluid produced due to evaporation stays in a vapor space and then condensed by a cooling piping. This cooling action continues until the temperature of the substrate W becomes equal to the boiling point of the operating fluid.

### SUMMARY OF THE INVENTION

It is an object of the present invention to provide a cooling technique by which at least one of the inconveniences described above can be solved.

This object is achieved by a temperature adjusting apparatus according to claim 1. Further developments are as set forth in the dependent claims related thereto.

Furthermore, a positioning apparatus according to claim 9, an exosure apparatus according to claim 12 and a device manufacturing method according to claim 14 are provided.

In aspects of the present invention, the necessity of applying an electric current in the vicinity of a subject of cooling as in the case using a Peltier device is removed, and also adverse influence on anything other than the subject of cooling, from cooling pipes, can be reduced.

Embodiments of the present invention will be described in conjunction with the accompanying drawings.

### BRIEF DESCRIPTION OF THE DRAWINGS

Figure 1 is a schematic view of a structure of a cooling mechanism according to a first embodiment of the present invention.
Figure 2 is a schematic view of a structure of a cooling mechanism according to a second embodiment of the present invention.
Figure 3 is a schematic view of a structure of a cooling mechanism according to a third embodiment of the present invention.
Figure 4 is a schematic view of a structure of a cooling mechanism according to a fourth embodiment of the present invention.
Figure 5 is a schematic view of a known example of positioning device, to which a radiation cooling mechanism embodying the present invention can be applied.
Figure 6 is a schematic view for explaining details of the radiation cooling mechanism of Figure 5.
Figure 7 is a flow chart for explaining sequence of device manufacturing processes.
Figure 8 is a flow chart for explaining details of a wafer process included in the procedure of Figure 7.
Figure 9 is a schematic view of an exposure apparatus of device manufacture, according to an embodiment of the present invention.

### DESCRIPTION OF THE PREFERRED EMBODIMENTS

Preferred embodiments of the present invention will now be described with reference to the attached drawings.

### [First Embodiment]

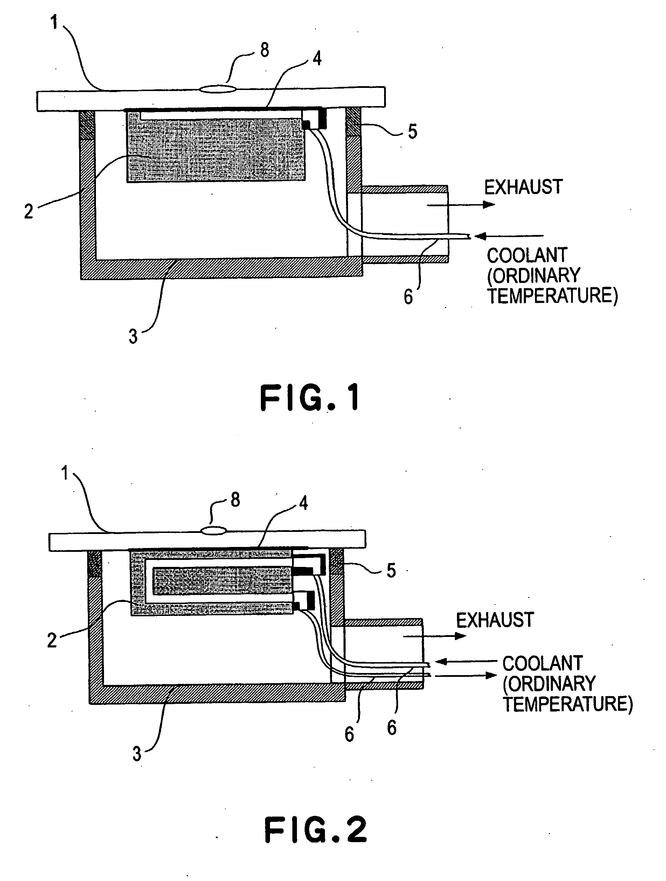

Figure 1 shows a cooling mechanism according to a first embodiment of the present invention. Figure 1 illustrates the structure for controlling a radiation plate temperature on the basis of heat of vaporization of water. Water which is temperature controlled to about the same temperature of the structure 110 and 211 (Figure 5) which constitutes a positioning device, that is, usually about 23 °C, is supplied to a porous material member 2 through a flowpassage 6. The porous material member 2 is disposed inside a container 3 which is vacuum exhausted by means of a vacuum pump, for example. The water supplied therein is dispersed within the porous material member 2 and, when a vapor pressure (or steam pressure) or lower pressure is reached, vaporization occurs. For example, the vapor pressure of water at 0 °C is 610 Pa and, therefore, by keeping the inside pressure of the container 3 at about 100 Pa, the water can be well vaporized even if the temperature of the porous material member 2 comes near to 0 °C. When vaporized, the water deprives vaporization heat from the porous material member 2 by 2440 J per 1 g. As a result, the temperature of the porous material member 2 gradually decreases and, thus, the temperature of a radiation plate 1 connected thereto is lowered. Therefore, even if the temperature of the water to be supplied is at an ordinary temperature, it is possible to decrease the temperature of the radiation plate to about 0 °C.

Theoretically, if the inside pressure of the container 3 is so controlled that the vapor pressure of the water is reached therein at the set temperature of the radiation plate 1, it enables such control cycle that, as the temperature of the radiation plate is lowered and it reaches the set temperature, vaporization of water stops, whereas when the temperature of the radiation plate 1 increases beyond the set temperature, vaporization of water resumes, whereby the temperature of the radiation plate 1 is automatically controlled at the set temperature.

Practically, however, the temperature precision of the radiation plate 1 or the response of temperature control is taken into account, the inside pressure of the container 3 is made sufficient small (not greater than 100 Pa) and, for the temperature control of the radiation plate 1, heating means such as a heater, for example, provided for the radiation plate 1 is used. For example, on the basis of an output of a temperature sensor 8, energization (on/off control or applied voltage) of a heater 4 disposed adjacent the radiation plate (at the back of radiation plate in the illustrated example) may be controlled. Here, if this cooling mechanism is used in an electron beam exposure apparatus, for example, a change in magnetic field due to variation of the electric current flowing through the heater may have an adverse influence. In consideration of this, the heater is made of a strand structure of high resistance wire material so that the magnetic field produced from the electric current flowing through the wire material can be cancelled. Furthermore, in order to prevent overcooling of peripheral components by the radiation plate 1, an insulating material 5 is provided between the radiation plate 1 and the peripheral structure to thereby suppress the heat transfer.

While this embodiment has been described with reference to an example wherein water having large vaporization heat is used as a coolant, any other coolant may be chosen from the standpoint of desired temperature, cooling rate, convenience in usage, for example. For example, if the radiation plate 1 should be controlled at 0 °C, ammonia may be used as a coolant. When the set temperature of the radiation plate 1 is not higher than 0 °C, if water is chosen as the coolant, the water may be solidified in the flowpassage 6 inside the porous material member 2. This can be avoided by using ammonia having low solidification temperature. The steam pressure of ammonia, namely, the pressure of vaporization, is higher than that of water, and it is 4.3 atm at 0 °C and 8.5 atm at 20 °C. Therefore, by supplying ammonia up to the porous material member at a very high supply pressure of 10 atm and by opening the container to the atmosphere (without exhausting it even to vacuum) to hold a pressure of about 1 atm, vaporization phenomenon well occurs and the cooling of the radiation plate is enabled. This means that the inside pressure of the container is not always negative, and it may be a positive pressure. Anyway, it should be maintained not greater than the steam pressure of the coolant at the set temperature.

Where the cooling mechanism described above is applied to the positioning device of Figure 5, the temperature of the radiation plate can be held at low temperature, like the case where a Peltier device 201 is used. Therefore, even in an environment wherein any Peltier device is unusable for any magnetic factor or the like, a cooling mechanism having a similar cooling effect can be incorporated into the positioning device. Therefore, radiation cooling even for an electron beam exposure apparatus, for example, can be achieved.

In this example, a radiation plate is taken as a subject of cooling. However, any other cooling subject may be taken. Furthermore, the subject of application of this cooling mechanism is not limited to a positioning device as described above.

A heat pipe is an example using vaporization heat, and Japanese Patent No. 2975089, corresponding to Japanese unexamined patent application No. 4168716, proposes an exposure apparatus using such mechanism. However, the heat pipe is such structure that a coolant confined in a closed space is vaporized, for cooling, in a higher-temperature region A of the container surface (usually, it is adjacent the subject of cooling) and then it is liquefied in a lower-temperature region (usually, it is a region cooled by a coolant) to emit heat. Thus, the heat pipe itself is not a cooling mechanism, but rather it is a mechanism for efficiently transmitting heat from the region A to the region B. If therefore such heat pipe is applied to the positioning device of Figure 5, although the radiation plate 1 may be cooled to a low temperature 10 °C due to the vaporization heat effect in the region A, it is still necessary to cool the region B to a temperature much lower than 10 °C. Furthermore, since the heat pipe has merely a large apparent heat conductivity, it is necessary to set a large temperature difference between the regions A and B in proportion to the physical length between the regions A and B. It is therefore practically difficult to separate the regions A and B by a large distance. In the structure according to this embodiment of the present invention, on the other hand, there is no portion corresponding to the "region B". Even if the exhaust means and the liquid supplying means are disposed far away from the portion corresponding to the "region A" within the limit allowed by the piping arrangement or the like, the cooling effect to the "region A" is unchanged. Thus, the cooling mechanism of this embodiment is definitely distinct from the heat pipe.

### [Second Embodiment]

Figure 2 shows a second embodiment of the present invention. This embodiment differs from the first embodiment in that water (coolant) is circulated through a porous material member 2 and that a portion of the circulated water is vaporized through the porous material member 2. Usually, a positioning device may be equipped with circulation of water for cooling. Thus, a portion of such circulation water may be bypassed toward the porous material member 2. In that occasion, there are advantages that the liquid pressure control is easy, and that the liquid is not easily solidified within the flowpassage 6 even if the set radiation plate temperature is low.

### [Third Embodiment]

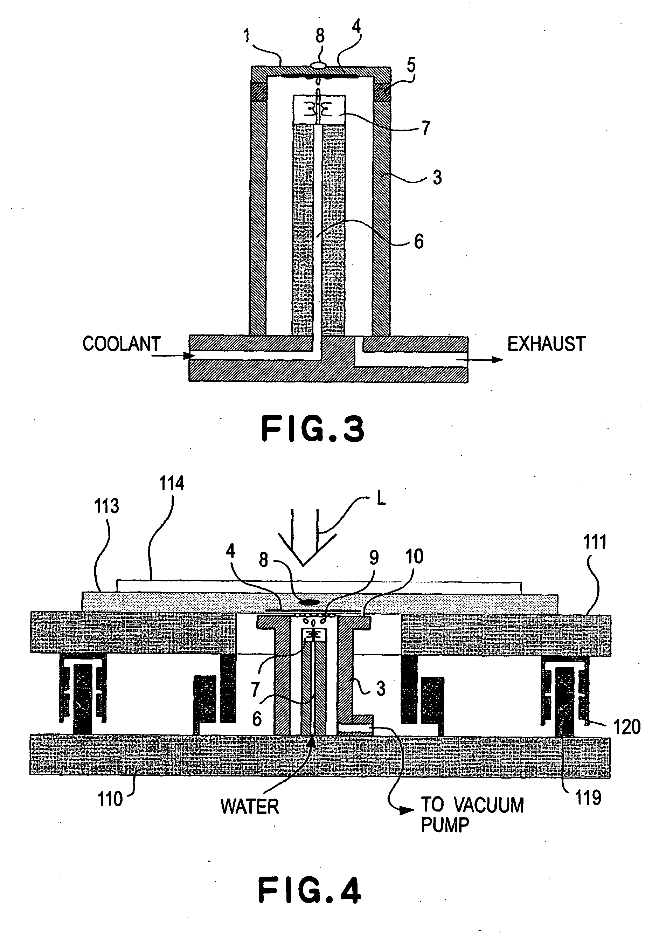

Figure 3 shows a third embodiment of the present invention. In the cooling mechanism of Figure 3, a liquid is directly applied against the back of a radiation plate. More specifically, water being supplied through a flowpassage 6 is applied (or discharged) from a nozzle 7 directly against the back of a radiation plate 1. Since the inside pressure of a vacuum container 3 is held by means of a vacuum pump (not shown), for example, at a pressure sufficiently smaller than the steam pressure of the water, the discharged water is vaporized while depriving, from the radiation plate, a heat quantity corresponding to the vaporization heat. With this arrangement, the radiation plate 1 can be cooled, and the temperature thereof can be reduced to about 0 °C. As described with reference to the first embodiment, the temperature control for the radiation plate may be carried out by controlling energization of a heater 4 provided adjacent the radiation plate (at the back of the radiation plate, in the illustrated example), on the basis of an output of a temperature sensor 8. Furthermore, if it is desired to change the cooling rate based on evaporation heat cooling, it may be effective to intentionally change the amount of discharge of water from the nozzle 7. In order to prevent thermal external disturbance to the radiation plate, an insulating material 5 is provided between the radiation plate and the peripheral structure. Here, as regards the water to be supplied to the nozzle 7, it is not specifically necessary to keep the same at low temperature. It may be at the same temperature (usually, about 23 °C) of the peripheral structure. Thus, without changing the structure temperature, the radiation plate can be maintained at low temperature, and so degradation of positioning precision due to thermal deformation is not a problem to be cared.

The required function of the nozzle 7 is just to discharge a coolant against the subject of cooling. It does not need a particular structure. A simple nozzle which uses a pressure difference between the flowpassage 6 and the inside of the container 3, may be used or, alternatively, a nozzle having an inside heat generating element for boiling the water to thereby discharge the same, may be used. As a further alternative, a nozzle having an inside piezoelectric device or the like for discharging water, may be used.

### [Fourth Embodiment]

Figure 4 shows a fourth embodiment of the present invention. While this embodiment has a basic stage structure similar to the Figure 5 structure, the cooling mechanism does not use radiation cooling but it is arranged to directly cool a chuck 113 by using vaporization heat. More specifically, water discharged from a nozzle 7 is directly applied against a chuck 113 which is the subject of cooling, and by vaporization of the water 9 adhered to the chuck surface, the chuck 113 is cooled. The inside pressure of a container 3 is exhausted and maintained by means of a vacuum pump (not shown), for example, at a pressure (about 100 Pa) corresponding to the steam pressure of the water. The chuck 113 functions as a portion of the vacuum container 3, and it is disposed opposed to a non-contact seal member 10 provided on the container body, with a small clearance intervening therebetween. With this arrangement, vibration or heat of a rough-motion stage 110 is prevented from being transmitted to the chuck. Additionally, because of vacuum seal effect of the small clearance, there occurs almost no leakage of a gas inside the container 3 to the vacuum ambience around the stage. For facilitating the temperature control of the chuck 113, while the required cooling rate is controlled by this cooling mechanism to some extent, additional temperature control may be made by use of chuck heating means 4 such as a heater, for example, on the basis of an output of a temperature sensor 8 provided to the chuck 113. Furthermore, if necessary, the cooling rate may be controlled by controlling the amount of'water discharge from the nozzle 7.

In accordance with the embodiments described above, a cooling mechanism using vaporization heat of coolant can be applied to a positioning device, with substantially the same cooling effect as attainable with Peltier device. It is therefore possible to meet electron beam exposure apparatus or the like wherein use of Peltier device is difficult. When the cooling mechanism is incorporated into a positioning device in an electron beam exposure apparatus or the like, high precision positioning and thus high precision exposure as well are assured.

### [Fifth Embodiment]

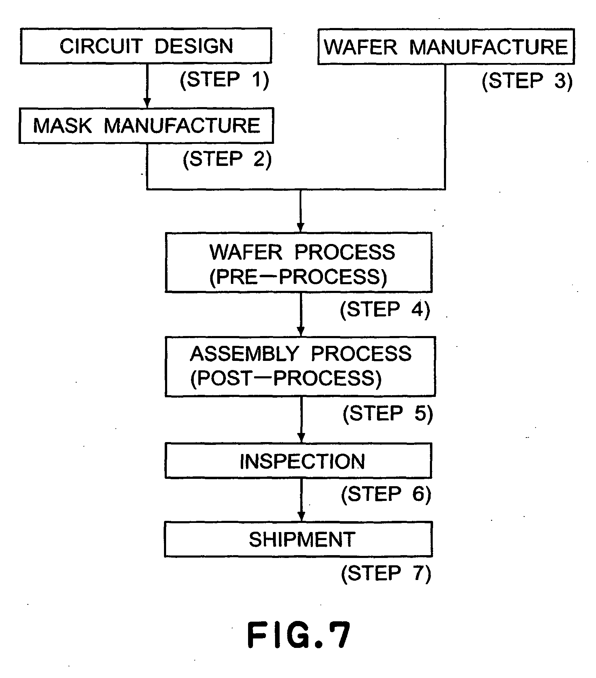

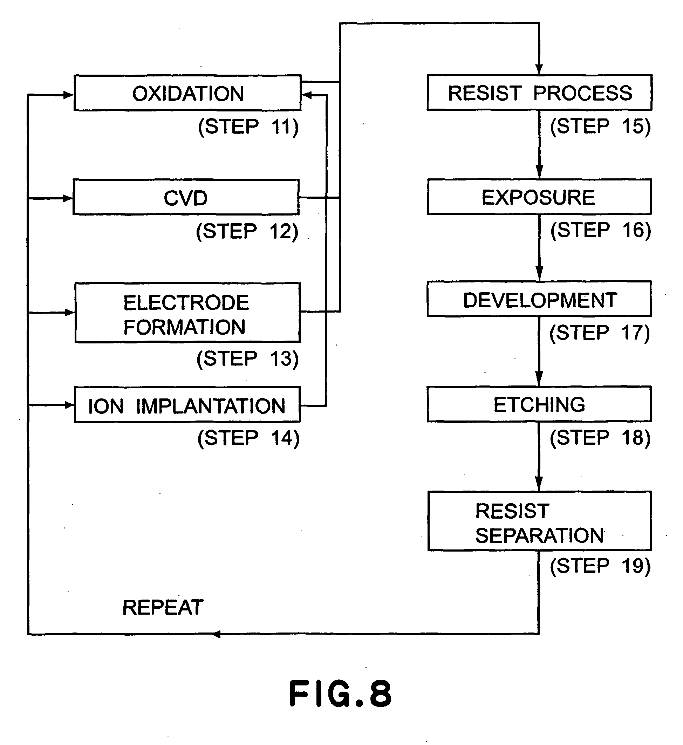

Next, referring to Figures 7 and 8, an embodiment of a device manufacturing method which uses an exposure apparatus described above, will be explained.

Figure 7 is a flow chart for explaining the procedure of manufacturing various microdevices such as semiconductor chips (e.g., ICs or LSIs), liquid crystal panels, CCDs, thin film magnetic heads or micro-machines, for example. Step 1 is a design process for designing a circuit of a semiconductor device. Step 2 is a process for making a mask on the basis of the circuit pattern design. Step 3 is a process for preparing a wafer by using a material such as silicon. Step 4 is a wafer process which is called a pre-process wherein, by using the thus prepared mask and wafer, a circuit is formed on the wafer in practice, in accordance with lithography. Step 5 subsequent to this is an assembling step which is called a post-process wherein the wafer having been processed at step 4 is formed into semiconductor chips. This step includes an assembling (dicing and bonding) process and a packaging (chip sealing) process. Step 6 is an inspection step wherein an operation check, a durability check an so on, for the semiconductor devices produced by step 5, are carried out. With these processes, semiconductor devices are produced, and they are shipped (step 7).

Figure 8 is a flow chart for explaining details of the wafer process. Step 11 is an oxidation process for oxidizing the surface of a wafer. Step 12 is a CVD process for forming an insulating film on the wafer surface. Step 13 is an electrode forming process for forming electrodes upon the wafer by vapor deposition. Step 14 is an ion implanting process for implanting ions to the wafer. Step 15 is a resist process for applying a resist (photosensitive material) to the wafer. Step 16 is an exposure process for printing, by exposure, the circuit pattern of the mask on the wafer through the exposure apparatus described above. Step 17 is a developing process for developing the exposed wafer. Step 18 is an etching process for removing portions other than the developed resist image. Step 19 is a resist separation process for separating the resist material remaining on the wafer after being subjected to the etching process. By repeating these processes, circuit patterns are superposedly formed on the wafer.

With these processes, high density microdevices can be manufactured.

### [Sixth Embodiment]

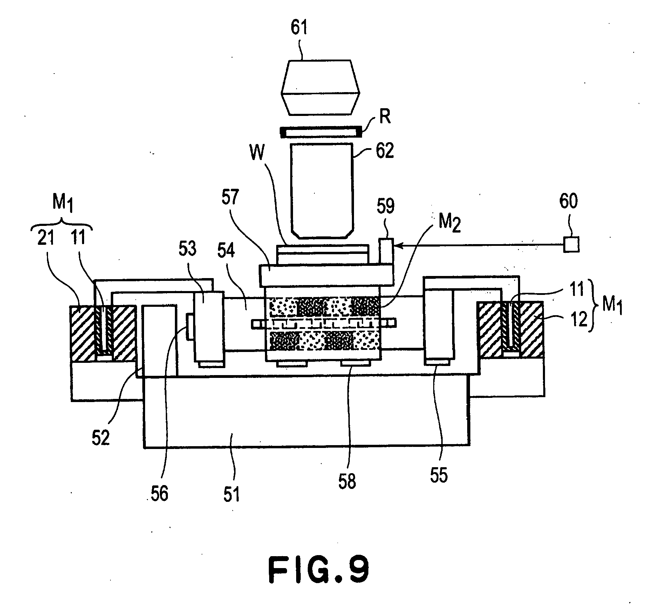

Figure 9 shows a semiconductor device manufacturing exposure apparatus in which a positioning device as described hereinbefore is incorporated as a wafer stage.

This exposure apparatus is to be used for manufacture of microdevices having a fine pattern formed thereon, such as semiconductor devices (semiconductor integrated circuits, for example), micromachines, or thin-film magnetic heads, for example. In this exposure apparatus, exposure light (which may include visible light, ultraviolet light, EUV light, X-ray, electron beam, and charged particle beam, for example) as an exposure energy supplied from a light source 61 illuminates a reticle R (original), and light from the reticle R is projected onto a semiconductor wafer W (substrate) through a projection system having a projection lens 62 (which may include refractive lens, reflective lens, catadioptric lens system, and charged particle lens, for example), whereby a desired pattern is produced on the substrate.

The exposure apparatus includes a base table 51 having a guide 52 and a linear motor stator 21 fixed thereto. The linear motor stator 21 has a multiple-phase electromagnetic coil, while a linear motor movable element 11 includes a permanent magnet group. The linear motor movable portion 11 is connected as a movable portion 53 to a movable guide 54 (stage), and through the drive of the linear motor M1, the movable guide 54 can be moved in a direction of a normal to the sheet of the drawing. The movable portion 53 is supported by a static bearing 55, taking the upper surface of the base table 51 as a reference, and also by a static bearing 56, taking the side surface of the guide 52 as a reference.

A movable stage 57 which is a stage member disposed to straddle the movable guide 54 is supported by a static bearing 58. This movable stage 57 is driven by a similar linear motor M2, so that the movable stage 57 moves leftwardly and rightwardly as viewed in the drawing, while taking the movable guide 54 as a reference. The emotion of the movable stage 57 is measured by means of an Interferometer 60 and a mirror 59 which is fixed to the movable stage 57.

A wafer (substrate) W is held on a chuck which is mounted on the movable stage 57, and a pattern of the reticle R is transferred in a reduced scale onto different regions on the wafer W by means of the light source 61 and the projection optical system 62, in accordance with a step-and-repeat method or a step-and-scan method.

It should be noted that the positioning device described hereinbefore can be similarly applied also to an exposure apparatus in which, without using a mask, a circuit pattern is directly drawn on a semiconductor water to expose a resist thereon.

Examples and embodiments can comprise various aspects which are listed in the following, wherein the invention is defined by the features of the appended claims.
(1) A positioning device having temperature adjusting means, wherein said temperature adjusting means includes a cooling mechanism based on vaporization heat of liquid. Since vaporization heat of liquid is used, there is no necessity of applying a relatively large electric current in the vicinity of a subject of cooling as in the case where a Peltier device is used. Therefore, even in an exposure apparatus using a charged particle beam such as electron beam, exposure precision is not adversely affected. Furthermore, even in a case where a radiation plate is disposed opposed to the subject of cooling and, by cooling the radiation plate, the cooling subject is cooled through radiation cooling, there is no necessity that the liquid for cooling the radiation plate has a large temperature difference with a coolant used to cool the structure of the positioning device. Moreover, as compared with a case wherein cooling pipes are stretched, factors which adversely affect the positioning precision can be removed. As a result, higher precision positioning is assured and, when the positioning device of this aspect of the present invention is incorporated into an exposure apparatus, higher precision exposure can be accomplished.
(2) A positioning device according to Item (1), wherein said cooling mechanism includes means for applying liquid to a portion to be cooled. A cooling mechanism based on vaporization heat is used in air conditioner, refrigerator, freezer, or the like. However they are all arranged to discharge a liquid into an inside space of a heat exchanger. To the inside. wall of the heat exchanger, the coolant is applied as a gas. As compared, in the structure according this aspect of the present invention, liquid coolant is directly applied to the portion to be cooled, such that vaporization heat is directly deprived from the portion to be cooled. The cooling efficiency can be therefore improved.
(3) A positioning device according to Item (2), wherein said cooling mechanism uses vaporization heat of liquid to cool the portion to be cooled at a temperature not higher than the temperature of the liquid applied to the portion to be cooled.
(4) A positioning device according to Item (2) or (3), wherein said cooling mechanism includes means for setting an ambience contacting to the portion to be cooled, at a pressure not higher than a steam pressure of the liquid at a set target temperature of the portion to be cooled.
(5) A positioning device according to any one of Items (2) - (4), wherein said ambience setting means includes a container for surrounding the ambience and means for exhausting the container.
(6) A positioning device according to Item (5), wherein the container comprises a subject of cooling or a cooling member, including said portion to be cooled, and a surrounding member disposed opposed to the cooling subject or cooling member with a small clearance intervening therebetween.
(7) A positioning device according to any one of Items (2) - (6), wherein said liquid applying means comprise means for discharging a liquid against the portion to be cooled. As regards the liquid, a liquid such as water which is kept in a liquid state at ordinary temperature and ordinary pressure, may be used. In that occasion, the cooling mechanism may preferably arranged so that the ambience contacting the portion to be cooled to held at vacuum of about 100 Pa while a liquid is discharged against the portion to be cooled. The portion to be cooled may be provided on a subject of cooling, or it may be provided on a cooling member disposed in contact with or opposed to the cooling subject.
(8) A positioning device according to any one of Items (2) - (6), wherein said liquid applying means comprises a liquid flowpassage provided inside a cooling member which includes the portion to be cooled and which is disposed in contact with or opposed to a subject of cooling, means for supplying a liquid to said liquide flowpassage, and means for communicating said flowpassage to an ambience contacting the portion to be cooled.
(9) A positioning device according to Item (8), wherein said liquid supplying means circulates the liquid through said liquid flowpassage.
(10) A positioning device according to Item (8) or (9), wherein said cooling member includes a porous material member which is the member to be cooled, and wherein said communicating means comprises a communication bore formed in said porous material member.
(11) A positioning device according to any one of Items (6) and (8) - (10), wherein the cooling member is made of a material having high heat conductivity and small thermal resistance with a subject of cooling. The cooling mechanism may have a structure that a liquid is supplied through a cooling member which is connected to a cooling subject and yet is in contact with vacuum, and also that the liquid flowpassage in the cooling member is communicated with the vacuum, Also, the cooling member may preferably be made of a porous material, for facilitating vaporization and improved cooling efficiency.
(12) A positioning device according to any one of Items (1) - (11), wherein said temperature adjusting means includes heating means.
(13) A positioning device according to Item (12), wherein said heating means comprises a strand structure of high resistance wire materials. When the temperature adjusting means comprises a structure having a heater, the temperature control of the cooling subject becomes easier. Where the heater has a stranded wire structure, variation of magnetic field produced from the current flowing through the heat is reduced.
(14) A positioning device according to any one of Items (1 - (13), wherein the liquid commonly used also as a coolant for cooling the structure of said positioning device, or it is controlled at substantially the same temperature as of that coolant.
(15) A cooling device, comprising a container, supplying means for supplying a liquid into said container, and means for exhausting said container.
(16) A cooling device according to Item (15), comprising a porous material member disposed in said container, for keeping the liquid therein.
(17) A cooling device according to Item (15) or (16), comprising collecting means for collecting the liquid from said container.
(18) A cooling device according to any one of Items (15) - (17), wherein a subject of cooling functions as at least a portion of said container.
(19) A cooling device according to any one of Items (15) - (18), wherein the subject of cooling is one of a radiation plate and a positioning device.
(20) A cooling device according to any one of Items (15) - (19), wherein said supplying means includes a nozzle for discharging the liquid into said container.
(21) A positioning device, comprising a holding member for holding an object, positioning means for positioning said holding member, and a cooling device as recited in any one of Items (15) - (20), wherein said holding member is a subject of cooling of said cooling device.
(22) An exposure apparatus including a cooling device as recited in any one of Items. (15) - (20).
(23) An exposure apparatus including a positioning device as recited in any one of Items (1) - (14).
(24) An exposure apparatus according to Item (23), wherein a substrate to be exposed is disposed in a vacuum, and wherein exposure is carried out by projecting an electron beam to the substrate to be exposed.
(25) A device manufacturing method, wherein a device is manufactured by use of an exposure apparatus as recited in any one of Items (22) - (24).

A subject of cooling and/or a cooling member may be provided inside a container or it may be structured as a portion of the container (Item (5) above) and, by vacuum exhausting the container, a cooling device (Item (18) above) can be provided. The Container may not be Completely closed, and it may include a portion which is defined by a structure having members opposed to each other with a small clearance intervening therebetween. Because of seal effect of the small clearance, the function as a container can still be kept, and also since the physical connection between the members is disconnected, thermal insulation and vibration insulation are achieved. When the cooling mechanism is applied to a radiation plate for performing radiation cooling, this advantage of cooling mechanism is best made use of. Particularly, this cooling mechanism is suited to an electron beam exposure apparatus.

While the invention has been described with reference to the structures disclosed herein, it is not confined to the details set forth, wherein the invention is limited by the subject matters of the appended claims only.

## Claims

1. A temperature adjusting apparatus for adjusting a temperature of an object (1; 113), the apparatus comprising:
a container (3);
a supplying unit (6, 7) configured to supply a liquid into a space surrounded by the object (1; 113) and said container (3); and
a pressure adjusting unit configured to adjust a pressure in the space to a pressure not higher than a vapor pressure of the liquid at a target temperature of the object (1; 113) so that the supplied liquid is vaporized so as to adjust a temperature of the object to a temperature not higher than the target temperature.

2. An apparatus according to Claim 1, further comprising a porous material member (2) disposed in said container (3) and connected to the object (1), the porous material member (2) being further configured to keep the liquid therein.

3. An apparatus according to Claim 1, wherein said supplying unit (6, 7) includes a porous material member (2) disposed in the space, the porous material member (2) including a flowpassage (6) and connecting the flowpassage (6) with the space.

4. An apparatus according to any of claims 1 to 3, further comprising a collecting unit (6) configured to collect the liquid from the space.

5. An apparatus according to any of claims 1 to 4, wherein the object (1;113) is one of a radiation plate and a positioning apparatus.

6. An apparatus according to any of claim 1 and claim 5 when being dependent on claim 1, wherein said supplying unit includes a nozzle (7) configured to discharge the liquid directly against the object (1; 113).

7. An apparatus according to any one of claims 1 to 6, further comprising a heater (4) configured to heat the object (1; 113) so as to adjust the temperature of the object (1; 113) to the target temperature.

8. An apparatus according to claim 7, wherein said heater (4) includes a strand structure of resistance wire material.

9. A positioning apparatus, comprising:
a holding unit (113) for holding an object;
a positioning unit (119, 120) for positioning the holding unit (113); and
a temperature adjusting apparatus according to any of claims 1 to 8 for adjusting a temperature of the holding unit (113) as the object for temperature adjustment or for adjusting a temperature of the holding unit via the object for temperature adjustment.

10. A positioning apparatus according to Claim 9, wherein said container includes a member (10) disposed opposed to the holding unit (113) with a clearance intervening therebetween, and configured such that the clearance is small enough to seal the space.

11. An exposure apparatus for exposing a substrate (114) to a pattern (L), said apparatus comprising:
a positioning apparatus according to any one of claims 9 and 10 configured to position the substrate.

12. An exposure apparatus according to Claim 11 wherein the substrate is exposed in a vacuum ambience.

13. A device manufacturing method, comprising the steps of:
exposing a substrate to a pattern by use of an exposure apparatus according to claim 11 or 12; and
developing the exposed substrate.

## Patentansprüche

1. Temperatureinstellvorrichtung zum Einstellen einer Temperatur eines Gegenstands (1; 113), wobei die Vorrichtung umfasst:
einen Behälter (3),
eine Zufuhreinheit (6, 7), die konfiguriert ist, eine Flüssigkeit in einen Raum zuzuführen, der durch den Gegenstand (1; 113) und den Behälter (3) umgeben ist, und
eine Druckeinstelleinheit, die konfiguriert ist, einen Druck in dem Raum auf einen Druck einzustellen, der nicht höher als ein Dampdruck der Flüssigkeit bei einer Zieltemperatur des Gegenstands (1; 113) ist, sodass die zugeführte Flüssigkeit verdampft wird, um eine Temperatur des Gegenstands auf eine Temperatur einzustellen, die nicht höher als die Zieltemperatur ist.

2. Vorrichtung nach Anspruch 1, ferner mit einem porösen Materialelement (2), das in dem Container (3) angeordnet ist und mit dem Gegenstand (1) verbunden ist, wobei das poröse Materialelement (2) ferner konfiguriert ist, die Flüssigkeit darin zu halten.

3. Vorrichtung nach Anspruch 1, wobei die Zufuhreinheit (6, 7) ein poröses Materialelement (2) umfasst, das in dem Raum angeordnet ist, wobei das poröse Materialelement (2) einen Durchflusskanal (6) umfasst und den Durchflusskanal (6) mit dem Raum verbindet.

4. Vorrichtung nach einem der Ansprüche 1 bis 3, ferner mit einer Sammeleinheit (6), die konfiguriert ist, die Flüssigkeit aus dem Raum zu sammeln.

5. Vorrichtung nach einem der Ansprüche 1 bis 4, wobei der Gegenstand (1; 113) eine Abstrahlplatte oder eine Positioniervorrichtung ist.

6. Vorrichtung nach einem des Anspruches 1 und des Anspruches 5, wenn er von Anspruch 1 abhängig ist, wobei die Zufuhreinheit eine Düse (7) umfasst, die konfiguriert ist, die Flüssigkeit direkt gegen den Gegenstand (1; 113) auszustoßen.

7. Vorrichtung nach einem der Ansprüche 1 bis 6, ferner mit einer Heizeinrichtung (4), die konfiguriert ist, den Gegenstand (1; 113) zu erwärmen, um die Temperatur des Gegenstands (1; 113) auf die Zieltemperatur einzustellen.

8. Vorrichtung nach Anspruch 7, wobei die Heizeinrichtung (4) einen Drahtaufbau aus einem Widerstandsdrahtmaterial umfasst.

9. Positionierungsgerät mit:
einer Halteeinheit (113) zum Halten eines Gegenstands,
einer Positioniereinheit (119, 120) zum Positionieren der Halteeinheit (113), und
einer Temperatureinstellvorrichtung nach einem der Ansprüche 1 bis 8 zum Einstellen einer Temperatur der Halteeinheit (113) als den Gegenstand für eine Temperatureinstellung oder zum Einstellen einer Temperatur der Halteeinheit über den Gegenstand für eine Temperatureinstellung.

10. Positionierungsvorrichtung nach Anspruch 9, wobei der Behälter ein Element (10) umfasst, das gegenüberliegend zu der Halteeinheit (113) mit einer dazwischen liegenden Lücke angeordnet ist, wobei es derart konfiguriert ist, dass die Lücke klein genug ist, um den Raum abzudichten.

11. Belichtungsgerät zur Belichtung eines Substrats (114) mit einem Muster (L), wobei die Vorrichtung umfasst:
ein Positioniergerät nach einem der Ansprüche 9 und 10, das konfiguriert ist, das Substrat zu positionieren.

12. Belichtungsgerät nach Anspruch 11, wobei das Substrat in einer Vakuumumgebung belichtet wird.

13. Vorrichtungsherstellungsverfahren, mit Schritten zum:
Belichten eines Substrats mit einem Muster unter Verwendung eines Belichtungsgeräts nach Anspruch 11 oder 12, und
Entwickeln des belichteten Substrats.

## Revendications

1. Appareil de réglage de température destiné à régler une température d'un objet (1 ; 113), l'appareil comprenant :
un récipient (3) ;
une unité d'alimentation (6, 7) configurée pour alimenter un liquide dans un espace entouré par l'objet (1 ; 113) et ledit récipient (3) ; et
une unité de réglage de pression configurée pour régler une pression dans l'espace à une pression ne dépassant pas une pression de vapeur du liquide à une température cible de l'objet (1 ; 113) de sorte que le liquide alimenté soit vaporisé de manière à régler une température de l'objet à une température ne dépassant pas la température cible.

2. Appareil selon la revendication 1, comprenant en outre un élément en matériau poreux (2) disposé dans ledit récipient (3) et relié à l'objet (1), l'élément en matériau poreux (2) étant en outre configuré pour maintenir le liquide en son sein.

3. Appareil selon la revendication 1, dans lequel ladite unité d'alimentation (6, 7) comporte un élément en matériau poreux (2) disposé dans l'espace, l'élément en matériau poreux (2) comportant un passage d'écoulement (6) et reliant le passage d'écoulement (6) à l'espace.

4. Appareil selon l'une des revendications 1 à 3, comprenant en outre une unité de collecte (6) configurée pour collecter le liquide à partir de l'espace.

5. Appareil selon l'une des revendications 1 à 4, dans lequel l'objet (1 ; 113) est l'un d'une plaque de rayonnement et d'un appareil de positionnement.

6. Appareil selon l'une des revendications 1 et 5 lorsqu'elle dépend de la revendication 1, dans lequel ladite unité d'alimentation comporte une buse (7) configurée pour décharger le liquide directement contre l'objet (1 ; 113).

7. Appareil selon l'une quelconque des revendications 1 à 6, comprenant en outre un dispositif de chauffage (4) configuré pour chauffer l'objet (1 ; 113) de manière à régler la température de l'objet (1 ; 113) à la température cible.

8. Appareil selon la revendication 7, dans lequel ledit dispositif de chauffage (4) comporte une structure toronnée d'un matériau de fil de résistance.

9. Appareil de positionnement, comprenant :
une unité de support (113) destinée à supporter un objet ;
une unité de positionnement (119, 120) destinée à positionner l'unité de support (113) ; et
un appareil de réglage de température selon l'une des revendications 1 à 8, pour régler une température de l'unité de support (113) comme l'objet pour le réglage de la température ou pour régler une température de l'unité de support via l'objet pour le réglage de température.

10. Appareil de positionnement selon la revendication 9, dans lequel ledit récipient comporte un élément (10) disposé en étant opposé à l'unité de support (113) avec un jeu intervenant entre ceux-ci, et configuré de sorte que le jeu soit suffisamment petit pour sceller l'espace.

11. Appareil d'exposition destiné à exposer un substrat (114) à un motif (L), ledit appareil comprenant :
un appareil de positionnement selon l'une quelconque des revendications 9 et 10, configuré pour positionner le substrat.

12. Appareil d'exposition selon la revendication 11, dans lequel le substrat est exposé dans une atmosphère sous vide.

13. Procédé de fabrication de dispositif, comprenant les étapes qui consistent :
à exposer un substrat à un motif en utilisant un appareil d'exposition selon la revendication 11 ou 12 ; et
à développer le substrat exposé.
